# EUROPEAN PATENT APPLICATION

(11) **EP 2 579 346 A1**
(43) Date of publication of application: **10.04.2013**
(21) Application number: 11789134.1
(22) Date of filing: 21.05.2011
(51) Int. Cl.: H01L 33/64

(54) **LED WITH HONEYCOMB RADIATING HEAT DISSIPATING DEVICE**

(30) Priority: 31.05.2010 CN 201020209032 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074471
(87) International publication number: WO 2011/150755

(57) **Abstract**

An LED with a honeycomb radiating heat dissipation device includes a sapphire substrate, an LED epitaxy layer on the sapphire substrate, a thermally conductive binding layer, an intermediate heat dissipation layer, a base substrate and a honeycomb-like heat dissipation device. The thermally conductive binding layer is provided to bind the sapphire substrate and the intermediate heat dissipation layer. The honeycomb-like heat dissipation device is in contact with the base substrate and includes a heat dissipation body and holes, each having a sidewall covered with a thermally radiative heat dissipation film. The intermediate heat dissipation layer and the thermally radiative heat dissipation film is made from a mixture of metal and nonmetal and has a microscopic surface structure with specific crystal, so as to provide high efficiency of heat dissipation by thermal radiation.

## Description

### BACKGROUND OF THE INVENTION

### 1. Field of the Invention

The present invention generally relates to a light emitting diode (LED) structure, and more specifically to an LED structure having a honeycomb radiating heat dissipation device.

### 2. The Prior Arts

An LED has high efficiency of light emitting as well as power saving and carbon reducing such that the LED has been widely used in many applications, especially selected as one of the possible light sources to replace the traditional light bulb, which generally consumes much electric power.

In general, the LED structure in the prior arts includes a sapphire substrate, an LED chip formed on the sapphire substrate, a leadframe, a sliver paste used to bind the leadframe and the sapphire substrate with the LED chip, a base substrate supporting the leadframe, connection lines configured to connect the LED chip to the leadframe, a package body enclosing the LED chip, and an aluminum heat sink connected to the base substrate.

The leadframe has an extension portion for penetrating through the base substrate to contact the aluminum heat sink under the base substrate. The heat generated by the LED chip is thus transferred to the aluminum heat sink by thermal conduction.

In the prior arts, there is one of the shortcomings in that the heat is primarily transferred by thermal conduction and the efficiency of heat dissipation depends on the effective area such that the traditional LED structure needs to increase the surface area and becomes considerably huge and heavy. As a result, it is inconvenient to use in the actual applications. In addition, the surface of the aluminum heat sink usually has a huge geometrical shape to cause the total size of the LED structure to be further increased such that the LED structure becomes much heavier.

Therefore, it is strongly desired to provide a new LED structure to implement high efficiency of heat dissipation without using any leadframe or aluminum heat sink so as to overcome the above problems in the prior arts.

### SUMMARY OF THE INVENTION

The primary objective of the present invention is to provide an LED structure with a honeycomb radiating heat dissipation device. The LED structure of the present invention includes an LED epitaxy layer, a sapphire substrate, a thermally conductive binding layer, an intermediate heat dissipation layer, a base substrate and a honeycomb heat dissipation device. The LED epitaxy layer is formed on the sapphire substrate. The thermally conductive binding layer is provided between the sapphire substrate and the intermediate heat dissipation layer to bind the sapphire substrate and the intermediate heat dissipation layer. The honeycomb heat dissipation device is in contact with the base substrate to provide heat dissipation by thermal radiation.

The honeycomb heat dissipation device includes a heat dissipation body and a plurality of holes, and each has an inner sidewall covered with a thermally radiative heat dissipation film. The intermediate heat dissipation layer and the thermally radiative heat dissipation film is made from a mixture of metal and nonmetal and has a microscopic surface structure with specific crystal, so as to provide high efficiency of heat dissipation by thermal radiation. Therefore, the working temperature of the LED epitaxy layer is greatly reduced to improve the stability of light emitting and the property of the emitted light as well as avoid functional failure or permanent damage.

### BRIEF DESCRIPTION OF THE DRAWINGS

The present invention can be understood in more detail by reading the subsequent detailed description in conjunction with the examples and references made to the accompanying drawings, wherein:

FIG. 1 is a view showing an LED structure having a honeycomb radiating heat dissipation device according to a first embodiment of the present invention;

FIG. 2 is a schematic view showing the honeycomb radiating heat dissipation device employed in the present invention;

FIG. 3 is a view showing an LED structure having a honeycomb radiating heat dissipation device according to a second embodiment of the present invention;

FIG. 4 is a view showing an LED structure having a honeycomb radiating heat dissipation device according to a third embodiment of the present invention; and

FIG. 5 is a view showing an LED structure having a honeycomb radiating heat dissipation device according to a fourth embodiment of the present invention.

### DETAILED DESCRIPTION OF THE PREFERRED EMBODIMENTS

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

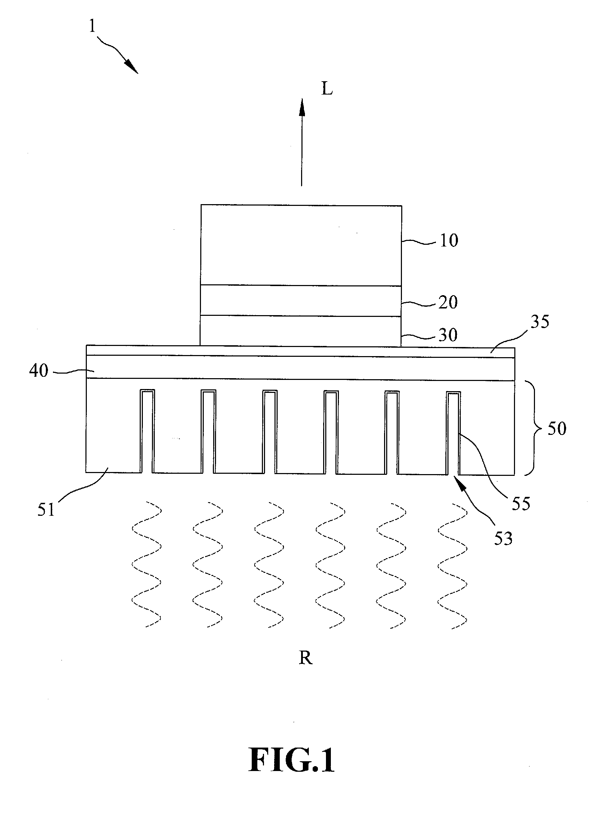

FIG. 1 clearly illustrates the LED structure having a honeycomb radiating heat dissipation device according to the first embodiment of the present invention. As shown in FIG. 1, the LED structure 1 of the present invention includes an LED epitaxy layer 10, a sapphire substrate 20, a thermally conductive binding layer 30, an intermediate heat dissipation layer 35, a base substrate 40, a honeycomb heat dissipation device 50, at least one electrical connection line (not shown) and a package body (not shown).

The LED epitaxy layer 10 is formed on the upper surface of the sapphire substrate 20, and includes at least an N type semiconductor layer, a semiconductor light emitting layer and a P type semiconductor layer, which are sequentially stacked. For instance, the N type semiconductor layer is an N type GaN (gallium nitride) layer, the semiconductor light emitting layer includes gallium nitride or indium gallium nitride, and the P type semiconductor layer is a P type GaN layer. Further, the P type semiconductor layer and the N type semiconductor layer are respectively connected to a positive end and a negative end of an external power source (not shown) by the at least one electrical connection line. The semiconductor light emitting layer can emit light when the LED epitaxy layer 110 is forward biased (or turned on) due to electron-hole recombination.

The package body includes silicone or epoxy resin used to enclose the LED epitaxy layer 10 for protection. Meanwhile, the package body may consist of certain amount of appropriate Phosphor powder, which can convert part of the original light generated by the LED epitaxy layer 10 into excited light with different wavelength. The excited light is then mixed with the remaining part of the original light to form resulting light. For example, blue light as the original light can be converted and mixed to form white light with a specific color temperature (CT).

The thermally conductive binding layer 30 with high thermal conductivity is provided between the sapphire substrate 20 and the intermediate heat dissipation layer 35 to bind the sapphire substrate 20 and the intermediate heat dissipation layer 35. Specifically, the thermally conductive binding layer 30 includes silver paste, tin paste, copper-tin alloy or gold-tin alloy. Thus, the thermally conductive binding layer 30 can propagate the heat generated by the LED epitaxy layer 10 through the sapphire substrate 20 towards the intermediate heat dissipation layer 35. That is, the heat generated by the LED epitaxy layer 10 is transferred to the intermediate heat dissipation layer 35 through the sapphire substrate 20 and thermally conductive binding layer 30 by thermal conduction.

More specifically, the intermediate heat dissipation layer 35 is provided on the upper surface of the bas substrate 40, and primarily includes a mixture of metal and nonmetal. The mixture of metal and nonmetal consists of at least one of silver, copper, tin, aluminum, titanium, iron and antimony, and one of oxide, nitride and inorganic acid of at least one of boron and carbon. For instance, the intermediate heat dissipation layer 35 consists of halide of titanium antimony. Additionally, the intermediate heat dissipation layer 35 has a microscopic structure with crystal, which has a grain size between one nanometer and tens of micrometers. It is believed that the crystal formed in the intermediate heat dissipation layer 35 can induce some specific lattice resonance to strongly emit corresponding thermal radiation, such as infrared or far infrared. Therefore, the heat propagated from the sapphire substrate 20 and thermally conductive binding layer 30 by thermal conduction is further transferred to the base substrate 40 by the intermediate heat dissipation layer 35.

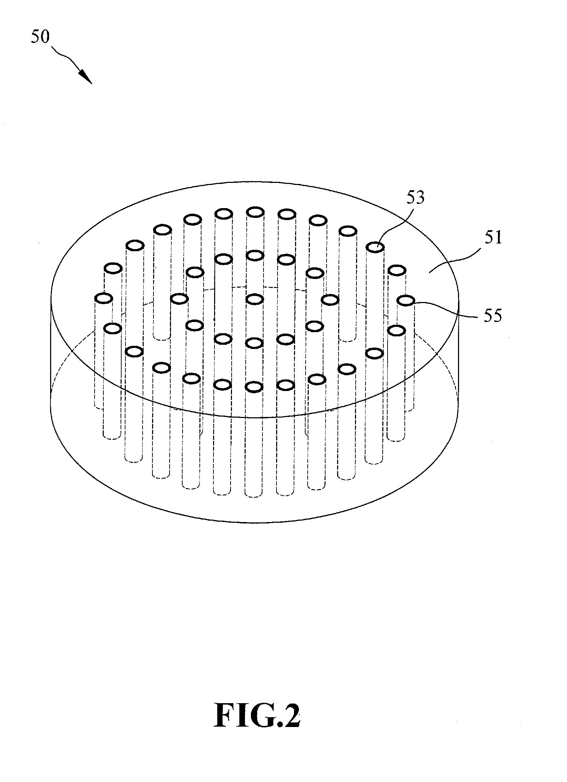

The honeycomb heat dissipation device 50 is connected to the lower surface of the base substrate 40, and includes a heat dissipation body 51 and a plurality of holes 53, which are non-through holes, and each hole 53 has an inner sidewall covered with a thermally radiative heat dissipation film 55, as shown in FIG. 2. The thermally radiative heat dissipation film 55 receives the heat propagated from the base substrate 40, and then transfers the heat received downwards and laterally by thermal radiation as specified by R in FIG. 1. The honeycomb heat dissipation device 50 in FIG. 2 having a shape of cylinder is only an illustrative example for clearly describing the aspect of the invention, and it is thus not intended to limit the scope of the present invention. The honeycomb heat dissipation device 50 of the present invention may have any shape.

The holes 53 can simultaneously perform heat dissipation to implement addition effect as if many antenna can enhance the transmitting power of the radio frequency wave such that the efficiency of the overall heat dissipation is greatly increased. It should be noted that the hole 53 having a circle shape in FIG. 2 is only an illustrative example, and not intended to limit the scope of the present invention. Therefore, the hole 53 may have a shape of circle, triangle, square, rectangle, rhombus, polygon or irregular form.

The thermally radiative heat dissipation film 55 is made from the mixture of metal and nonmetal and has the microscopic structure similar to the intermediate heat dissipation layer 35 in the above mention, and the detailed description is thus omitted.

To improve the quality of the thermally radiative heat dissipation film 55, certain suitable material is selected to form the heat dissipation body 51, and more specifically, the difference between thermal expansion coefficients of the thermally radiative heat dissipation film 55 and the heat dissipation body 51 is not greater than 0.1%.

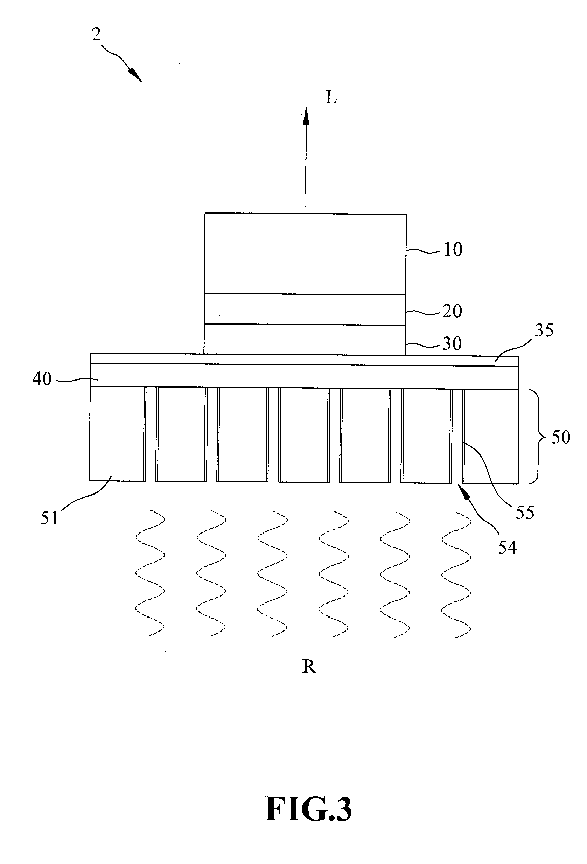

FIG. 3 illustrates the LED structure 2 according to the second embodiment of the present invention. It should be noted that the second embodiment is similar to the LED structure 1 of the first embodiment in FIG. 1, and the primary difference is that the honeycomb heat dissipation device 50 of the LED structure 2 has a plurality of holes 54, which are through holes instead of the non-through holes as shown in FIG. 1. Alternatively, part of the holes 54 are implemented as the through holes and the others are the non-through holes. Or, the holes 54 are configured as a straight tube or curved tube, and each hole 54 has a shape of circle, triangle, square, rectangle, rhombus, polygon or irregular form. Therefore, the overall surface area of the thermally radiative heat dissipation film 55 is increased so as to improve the efficiency of heat dissipation.

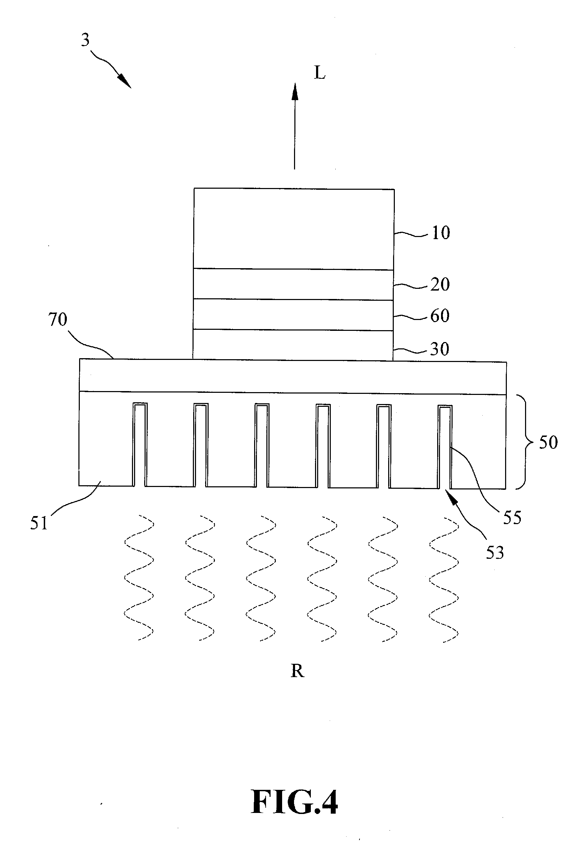

As shown in Fig. 4, the LED structure 3 according to the third embodiment of the present invention includes an LED epitaxy layer 10, a sapphire substrate 20, a thermally conductive binding layer 30, a first thermally radiative heat dissipation film 60, a second thermally radiative heat dissipation film 70, a honeycomb heat dissipation device 50, at least one electrical connection line (not shown) and a package body (not shown).

The sapphire substrate 20 has an upper surface and a lower surface. The epitaxy layer 10 is formed on the upper surface of the sapphire substrate 20. The epitaxy layer 10 and the honeycomb heat dissipation device 50 are similar to what are described for the LED structure 1 in FIG. 1, and the first thermally radiative heat dissipation film 60 and the second thermally radiative heat dissipation film 70 are similar to the thermally radiative heat dissipation film 55 of the honeycomb heat dissipation device 50 in FIG. 2. Therefore, the same function and aspects related will not be repeated.

The honeycomb heat dissipation device 50 has an upper surface and a lower surface, and the holes 53 are provided on the lower surface. The first thermally radiative heat dissipation film 60 is formed on the lower surface of the sapphire substrate 20 and the second thermally radiative heat dissipation film 70 is formed on the upper surface of the honeycomb heat dissipation device 50. The thermally conductive binding layer 30 is provided between the first thermally radiative heat dissipation film 60 and the second thermally radiative heat dissipation film 70 to bind the first thermally radiative heat dissipation film 60 and the second thermally radiative heat dissipation film 70.

The third embodiment of the LED structure 3 uses the first thermally radiative heat dissipation film 60 to propagate the heat from the LED epitaxy layer 10 through the sapphire substrate 20 downwards by thermal radiation, and similarly, the second thermally radiative heat dissipation film 70 is used to transfer the heat from the first thermally radiative heat dissipation film 60 through the thermally conductive binding layer 30 downwards by thermal radiation. Additionally, the thermally radiative heat dissipation film 55 on the inner sidewall of the holes 53 can propagate the heat outwards by the mechanism of thermal radiation specified by R. As a result, the third embodiment of the LED structure 3 can further improve the efficiency of heat dissipation.

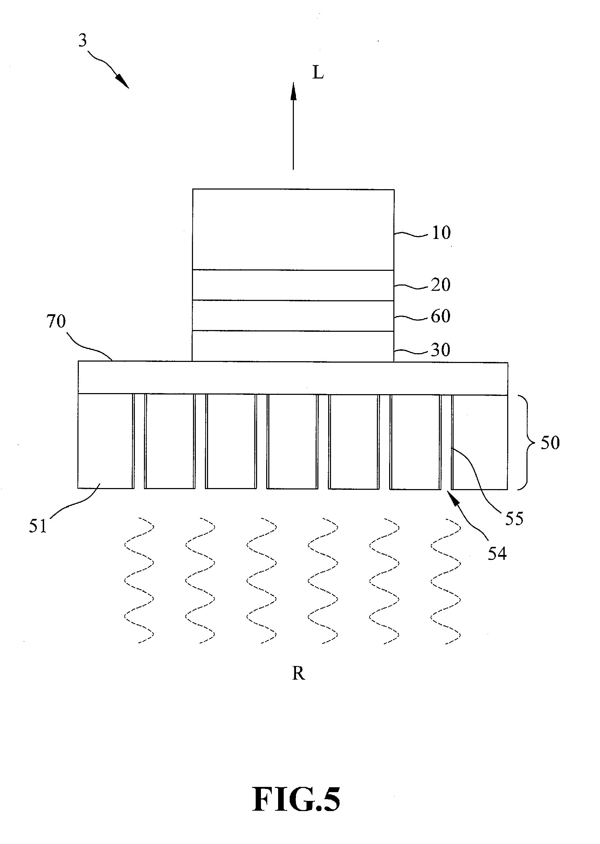

FIG. 5 illustrates the LED structure 3 according to the fourth embodiment of the present invention. The LED structure 3 in FIG. 5 is similar to the LED structure 3 in the above third embodiment, and the difference is that the holes 54 of the honeycomb heat dissipation device 50 are the through holes instead of non- through holes. Thus, the characteristics of the other elements are not repeatedly described here.

Although the present invention has been described with reference to the preferred embodiments, it will be understood that the invention is not limited to the details described thereon. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A light emitting diode (LED) with a honeycomb radiating heat dissipation device, comprising:
a sapphire substrate having an upper surface and a lower surface;
an LED epitaxy layer formed on the upper surface of the sapphire substrate, including at least an N type semiconductor layer, a semiconductor light emitting layer and a P type semiconductor layer, which are sequentially stacked;
a base substrate having an upper surface and a lower surface;
an intermediate heat dissipation layer formed on the upper surface of the base substrate;
a thermally conductive binding layer provided between the lower surface of the sapphire substrate and the intermediate heat dissipation layer to bind the sapphire substrate and the intermediate heat dissipation layer;
a honeycomb heat dissipation device including a heat dissipation body and a plurality of holes, each having an inner sidewall covered with a thermally radiative heat dissipation film, wherein the honeycomb heat dissipation device is connected to the lower surface of the base substrate;
at least one electrical connection line electrically connecting the N type semiconductor layer and the P type semiconductor layer to a positive end and a negative end of an external power source, respectively; and
a package body enclosing the LED epitaxy layer,
wherein, the thermally radiative heat dissipation film consists of a mixture of metal and nonmetal, which consists of at least one of silver, copper, tin, aluminum, titanium, iron and antimony, and one of oxide, nitride and inorganic acid of at least one of boron and carbon, and the thermally radiative heat dissipation film has a microscopic structure with crystal.

2. The LED as claimed in claim 1, wherein the intermediate heat dissipation layer and the thermally radiative heat dissipation film consist of the crystal with a grain size between one nanometer and tens of micrometers, and a difference between thermal expansion coefficients of the thermally radiative heat dissipation film and the heat dissipation body is not greater than 0.1 %.

3. The LED as claimed in claim 1, wherein each hole of the honeycomb heat dissipation device is a through hole or none-through hole configured as a straight tube or curved tube, and each hole has a shape of circle, triangle, square, rectangle, rhombus, polygon or irregular form.

4. An LED with a honeycomb radiating heat dissipation device, comprising:
a sapphire substrate having an upper surface and a lower surface;
an LED epitaxy layer formed on the upper surface of the sapphire substrate, including at least an N type semiconductor layer, a semiconductor light emitting layer and a P type semiconductor layer, which are sequentially stacked;
a first thermally radiative heat dissipation film formed on the lower surface of the sapphire substrate;
a honeycomb heat dissipation device having an upper surface and a lower surface, wherein the honeycomb heat dissipation device includes a heat dissipation body and a plurality of holes, and the holes are provided on the lower surface of the honeycomb heat dissipation device, each having an inner sidewall covered with a thermally radiative heat dissipation film;
a second thermally radiative heat dissipation film formed on the upper surface of the honeycomb heat dissipation device;
a thermally conductive binding layer provided between the first thermally radiative heat dissipation film and the second thermally radiative heat dissipation film to bind the first thermally radiative heat dissipation film and the second thermally radiative heat dissipation film;
at least one electrical connection line electrically connecting the N type semiconductor layer and the P type semiconductor layer to a positive end and a negative end of an external power source, respectively; and
a package body enclosing the LED epitaxy layer,
wherein, the thermally radiative heat dissipation film, each of the first thermally radiative heat dissipation film and the second thermally radiative heat dissipation film consists of a mixture of metal and nonmetal, which consists of at least one of silver, copper, tin, aluminum, titanium, iron and antimony, and one of oxide, nitride and inorganic acid of at least one of boron and carbon, and the thermally radiative heat dissipation film has a microscopic structure with crystal.

5. The LED as claimed in claim 4, wherein the thermally radiative heat dissipation film consists of the crystal with a grain size between one nanometer and tens of micrometers, and a difference between thermal expansion coefficients of the thermally radiative heat dissipation film and the heat dissipation body is not greater than 0.1%.

6. The LED as claimed in claim 4, wherein each hole of the honeycomb heat dissipation device is a through hole or none-through hole configured as a straight tube or curved tube, and each hole has a shape of circle, triangle, square, rectangle, rhombus, polygon or irregular form.
